Europäisches Patentamt

European Patent Office

Office européen des brevets

(19)

(11) **EP 0 760 553 B1**

(12) **FASCICULE DE BREVET EUROPEEN**

(45) Date de publication et mention
de la délivrance du brevet:
**07.11.2001 Bulletin 2001/45**

(51) Int Cl.⁷: **H03D 3/02**

(21) Numéro de dépôt: **96401843.6**

(22) Date de dépôt: **28.08.1996**

(54) **Dispositif démodulateur d'un signal modulé en fréquence**

Demodulator für frequenzmoduliertes Signal

Demodulator for a frequency-modulated signal

(84) Etats contractants désignés:
**CH DE FR GB LI**

(30) Priorité: **30.08.1995 FR 9510234**

(43) Date de publication de la demande:
**05.03.1997 Bulletin 1997/10**

(73) Titulaire: **CSEM Centre Suisse d'Electronique et de Microtechnique S.A.**
**2007 Neuchâtel (CH)**

(72) Inventeurs:
• **Gerrits, Johannes Franciscus Maria**
**75116 Paris (FR)**
• **Pardoen, Matthijs Daniel**
**75116 Paris (FR)**

(74) Mandataire: **Ballot, Paul et al**
**Cabinet Ballot**
**7, rue Le Sueur**
**75116 Paris (FR)**

(56) Documents cités:
**GB-A- 2 144 004          US-A- 4 603 301**

## Description

L'invention concerne les récepteurs de signaux modulés en fréquence et, plus particulièrement dans de tels récepteurs, un dispositif pour démoduler un signal modulé en fréquence autour d'une fréquence intermédiaire. Elle concerne également, dans un tel dispositif démodulateur, des circuits additionnels pour réaliser le contrôle automatique de fréquence et la suppression du signal démodulé lorsque le rapport signal/bruit est inférieur à une certaine valeur.

Les récepteurs radio fonctionnant en modulation de fréquence utilisent habituellement des signaux à des fréquences intermédiaires de 455 Kilohertz ou de 10,7 Mégahertz. Pour démoduler ces signaux à fréquence intermédiaire, on utilise un détecteur dit à quadrature de phase qui requiert un circuit résonant à la fréquence intermédiaire. Aux fréquences indiquées ci-dessus, ce circuit résonant comprend une bobine qui ne peut être sous la forme d'un circuit intégré. On peut utiliser un circuit à résistance-condensateur lorsque la fréquence intermédiaire est plus basse, par exemple 70 Kilohertz mais, dans ce cas, la valeur requise pour la capacité du condensateur n'est pas réalisable dans un circuit intégré.

Ces circuits de démodulation de type analogique qui comportent un circuit résonant ou un circuit résistance-condensateur ont une bande passante limitée et présentent une distorsion dans la gamme des fréquences audio du fait que le retard introduit par le circuit résonant ou le circuit résistance-condensateur dépend de la fréquence et, par conséquent, ne représente qu'un délai constant dans une bande passante limitée autour de la fréquence intermédiaire.

Il existe des circuits de démodulation à fréquence intermédiaire qui sont du type numérique mais ils requièrent des circuits intégrés complexes comportant des mémoires pour réaliser les calculs des fonctions de démodulation.

Un but de la présente invention est donc de réaliser un dispositif démodulateur de type entièrement numérique et qui ne présente pas les inconvénients de ceux de l'art antérieur, qu'ils soient de type analogique ou de type numérique.

Les récepteurs radio en modulation de fréquence comportent habituellement un dispositif de contrôle automatique de la fréquence qui permet de maintenir automatiquement dans certaines limites l'accord optimal en fréquence du récepteur. Un tel dispositif est souvent réalisé en utilisant, comme signal d'erreur, un signal qui provient du filtrage passe-bas du signal démodulé. Cette manière de faire a pour inconvénient que le dispositif démodulateur et le dispositif automatique de contrôle de la fréquence partagent la même fonction de transfert ; ceci a pour conséquence que la sensibilité du dispositif démodulateur ne peut être augmentée sans affecter le comportement de la boucle de contrôle automatique de fréquence et il peut en résulter des verrouillages sur des fréquences autres que celle recherchée.

Un autre but de la présente invention est donc de réaliser, dans un dispositif démodulateur de type numérique, un dispositif de contrôle automatique de fréquence de type numérique dans lequel les fonctions de transfert du dispositif démodulateur et du dispositif de contrôle automatique ont été découplées de sorte que la sensibilité de la démodulation peut être rendue optimale sans affecter les performances du contrôle automatique de fréquence.

Les récepteurs radio en modulation de fréquence comportent également un dispositif de suppression du signal démodulé lorsque le rapport signal/bruit de ce dernier devient faible. Plusieurs solutions sont actuellement mises en oeuvre pour obtenir cette suppression.

L'une des solutions consiste à mesurer l'amplitude du signal à fréquence intermédiaire et de comparer cette mesure à un seuil : lorsque la mesure est inférieure au seuil, le signal démodulé est supprimé. Un tel détecteur de seuil est difficile à réaliser dans des circuits à très basse tension d'alimentation et complique la réalisation.

Une deuxième solution consiste à mesurer les composantes haute fréquence dans le signal démodulé grâce à un circuit détecteur de bruit. Un tel circuit détecteur requiert un filtrage pour éliminer le bruit à fréquence audio, ce qui implique l'utilisation de composants disposés à l'extérieur du circuit intégré.

Une troisième solution consiste à mesurer la déviation du signal à fréquence intermédiaire à l'aide d'un circuit de corrélation mais ce circuit requiert également l'utilisation de composants disposés à l'extérieur du circuit intégré.

Un autre but de la présente invention est donc de réaliser, dans un dispositif démodulateur de type numérique, un dispositif de suppression du signal modulé de type numérique entièrement intégré.

Le brevet GB 2 144 004 décrit un dispositif de démodulation d'un signal modulé en fréquence qui utilise un circuit multiplicateur auquel sont appliqués le signal modulé sous forme d'un signal rectangulaire et le même signal rectangulaire mais retardé par une ligne à retard numérique. Un tel dispositif ne prévoit pas un contrôle du retard introduit en fonction de la fréquence, ni une suppression du signal démodulé lorsque le rapport signal/bruit devient faible.

L'invention concerne donc un dispositif de démodulation d'un signal modulé en fréquence $F_M$ autour d'une fréquence intermédiaire $f_i$ comprenant :

- un circuit de transformation du signal modulé en fréquence $F_M$ en un signal rectangulaire $F_{MR}$,
- une première ligne à retard de type numérique à la borne d'entrée de laquelle est appliqué le signal rectangulaire $F_{MR}$ ladite ligne à retard fournissant sur une borne de sortie un signal rectangulaire $F_{MR1}$ qui est retardé d'un temps τ égal à (2m+1)/(4f$_i$) un premier circuit multiplicateur aux deux bornes d'entrée duquel sont appliqués le signal rectangulaire F$_{MR}$ et le signal retardé F$_{MR1}$ et qui fournit un signal démodulé F$_{R1}$ et

- un premier filtre passe-bas à la borne d'entrée duquel est appliqué le signal de sortie F$_{R1}$ du premier circuit multiplicateur et qui fournit sur sa borne de sortie un signal démodulé, caractérisé en ce qu'il comprend, en outre, :

    - une deuxième ligne à retard de type numérique à la borne d'entrée de laquelle est appliqué le signal rectangulaire F$_{MR}$, ladite ligne à retard fournissant sur une borne de sortie un signal rectangulaire F$_{MR2}$ qui est retardé d'un temps égal à 2τ/3

    - un deuxième circuit multiplicateur aux deux bornes d'entrée duquel sont appliqués le signal rectangulaire F$_{MR}$ de sortie du circuit de transformation et le signal retardé F$_{MR2}$ de sortie de ladite deuxième ligne à retard et qui fournit un signal F$_{R2}$,

    - un deuxième filtre passe-bas pour filtrer le signal F$_{R2}$ fourni par ledit deuxième circuit multiplicateur,

    - un comparateur à la borne d'entrée duquel est appliqué le signal filtré et qui fournit un signal lorsque le signal filtré est inférieur à un seuil prédéterminé, et

    - une porte électronique qui reçoit le signal démodulé et filtré fourni par ce premier filtre passe-bas et qui est commandé par le signal de sortie du comparateur.

Selon un autre aspect de la présente invention, le dispositif de démodulation comprend également un circuit de contrôle automatique de la fréquence comprenant :

- une troisième ligne à retard de type numérique à la borne d'entrée de laquelle est appliqué le signal rectangulaire F$_{MR}$, ladite ligne à retard fournissant sur une borne de sortie un signal rectangulaire F$_{MR3}$ qui est retardé d'un temps égal à τ/3

- un troisième circuit multiplicateur aux deux bornes d'entrée duquel sont appliqués le signal rectangulaire F$_{MR}$ de sortie du circuit de transformation et le signal retardé F$_{MR3}$ de sortie de la troisième ligne à retard et qui fournit un signal F$_{R3}$,

- un circuit intégrateur auquel est appliqué le signal de sortie F$_{R3}$ du troisième circuit multiplicateur, et

- un oscillateur contrôlé en tension auquel est appliqué le signal de sortie du circuit intégrateur qui fournit des impulsions CK, lesdites impulsions étant appliquées auxdites première, deuxième et troisième lignes à retard de type numérique de manière à décaler le signal F$_{MR}$ à chaque impulsion.

Selon un autre aspect de la présente invention, les première, deuxième et troisième lignes à retard sont réalisées à l'aide d'une seule ligne à retard de retard total égal à 3/(4f$_i$) et qui comporte trois bornes de sortie correspondant respectivement à des retards égaux à 1/(4f$_i$) pour le circuit de contrôle automatique de fréquence, 1/(2f$_i$) pour le circuit de suppression du signal démodulé et 3/(4f$_i$) pour le circuit démodulateur proprement dit.

Les lignes à retard sont réalisées à l'aide de registres à décalage dont le décalage est commandé par les signaux fournis par le circuit de contrôle automatique de fréquence.

D'autres caractéristiques et avantages de la présente invention apparaîtront à la lecture de la description suivante d'un exemple particulier de réalisation, ladite description étant faite en relation avec les dessins joints dans lesquels :

- la figure 1 est un schéma d'un dispositif démodulateur selon la présente invention,
- les figures 2-A et 2-B sont des diagrammes temporels montrant la transformation d'un signal analogique modulé en fréquence en un signal rectangulaire ;
- les figures 3-A à 3-G sont des diagrammes temporels montrant les formes des signaux à différents points du dispositif démodulateur selon la présente invention ;
- la figure 4 montre des courbes de réponse en fonction de la fréquence des facteurs de forme des signaux de sortie des circuits de démodulation, de suppression du signal démodulé et de contrôle automatique de fréquence, et
- la figure 5 montre des courbes de réponse en fonction de la fréquence du facteur de forme des signaux de sortie du circuit démodulateur pour différentes valeurs entières du coefficient "m".

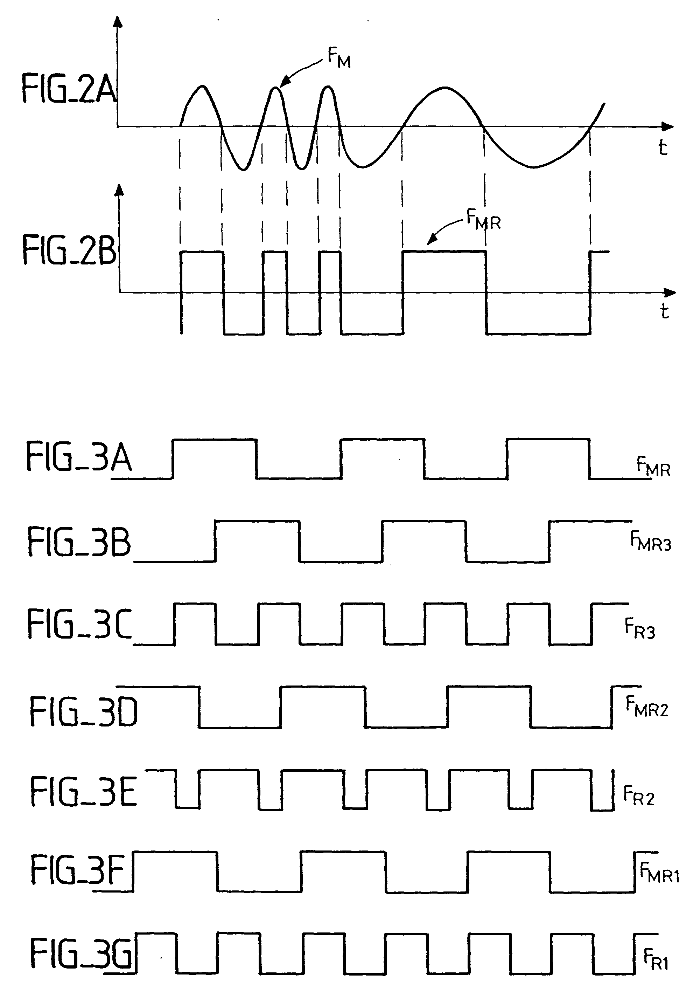

Le dispositif démodulateur selon l'invention d'un signal analogique F$_M$ modulé en fréquence constitue une partie d'un récepteur radio de signaux modulés en fréquence. Un tel signal F$_M$ est représenté schématiquement par le diagramme temporel de la figure 2-A et varie en fréquence autour d'une fréquence intermédiaire f$_i$ qui, dans l'exemple particulier décrit, sera telle que f$_i$ = 25 kHz.

Le signal F$_M$ est appliqué à un circuit 12 qui le transforme en un signal rectangulaire F$_{MR}$ représenté schématiquement par le diagramme temporel de la figure 2-B ou celui de la figure 3-A pour une fréquence stable.

Le signal F$_{MR}$ (Figure 3-A) est appliqué à une ligne à retard 14 de type numérique qui comprend trois sections 16, 18 et 20 en série ou cascade introduisant chacune un retard τ/3 avec τ = 3/4f$_i$. Une telle ligne à retard comprend des registres à décalage dont le nombre sera déterminé ci-après et dont les états sont transférés d'un étage au suivant à la cadence d'un signal d'horloge CK fourni par un oscillateur 36 d'un circuit de contrôle automatique de fréquence qui sera décrit ci-après.

La première section 16 de la ligne à retard, qui fournit un signal $F_{MR3}$ (Figure 3-B) retardé de $\tau/3 = 1/4f_i$ par rapport au signal $F_{MR}$, comprend une borne de sortie qui est connectée, d'une part, à la borne d'entrée de la section suivante 18 et, d'autre part, à une des deux bornes d'entrée d'un circuit OU EXCLUSIF 26 dont l'autre borne d'entrée est connectée à la borne de sortie du circuit 12 (signal $F_{MR}$), c'est-à-dire en fait à la borne d'entrée de la ligne de retard 14.

La borne de sortie du circuit OU EXCLUSIF 26, qui fournit un signal $F_{R3}$ (Figure 3-C), est connectée à la borne d'entrée d'un circuit intégrateur 34 dont la borne de sortie est connectée à une borne d'entrée de commande d'un oscillateur contrôlé en tension 36, plus connu sous l'acronyme anglo-saxon VCO pour "Voltage Controlled Oscillator". C'est cet oscillateur 36 qui fournit le signal d'horloge CK qui est appliqué aux entrées de commande de décalage des registres à décalage des différentes sections 16, 18 et 20 de la ligne à retard 14.

La section 18 de la ligne à retard 14 introduit un retard supplémentaire $\tau/3$ au signal $F_{MR}$ (en fait $F_{MR3}$) pour fournir sur sa borne de sortie un signal $F_{MR2}$ (Figure 3-D) qui présente un retard de $2\tau/3 = 1/2f_i$ par rapport au signal $F_{MR}$ (Figure 3-D). La borne de sortie de la section 18 est connectée, d'une part, à la borne d'entrée de la troisième section 20 de la ligne à retard et, d'autre part, à une des deux bornes d'entrée d'un circuit OU EXCLUSIF 24, l'autre borne d'entrée étant connectée à la borne de sortie du circuit 12 (signal $F_{MR}$).

La borne de sortie du circuit OU EXCLUSIF 24, qui fournit un signal $F_{R2}$ (Figure 3-E), est connectée à la borne d'entrée d'un circuit 42 constitué d'un filtre passe-bas 32 suivi d'un comparateur 40 à cycle d'hystérésis. Le comparateur 40 a un seuil prédéterminé au-dessous duquel il fournit un signal logique de fermeture d'une porte électronique 30 d'un circuit 38 qui sera décrit ci-après.

La section 20 de la ligne à retard 14 introduit un retard supplémentaire $\tau/3$ au signal $F_{MR}$ (en fait $F_{MR2}$) pour fournir sur sa borne de sortie un signal $F_{MR1}$ (Figure 3-F) qui présente un retard $\tau = 3/4f_i$ par rapport au signal $F_{MR}$ (Figure 3-A). La borne de sortie de la section 20 est connectée à une des deux bornes d'entrée d'un circuit OU EXCLUSIF 22, l'autre borne d'entrée étant connectée à la borne de sortie du circuit 12 (signal $F_{MR}$).

La borne de sortie du circuit OU EXCLUSIF 22, qui fournit un signal $F_{R1}$ (Figure 3-G), est connectée à la borne d'entrée d'un circuit 38 qui comprend, en série, un filtre passe-bas 28 et la porte électronique 30.

C'est sur la borne de sortie de la porte électronique 30 qu'apparaît le signal démodulé à la fréquence audio en l'absence du signal de suppression fourni par le circuit 42.

Les circuits OU EXCLUSIF 22, 24 et 26 réalisent la multiplication du signal numérique $F_{MR}$ avec les trois signaux retardés $F_{MR1}$, $F_{MR2}$ et $F_{MR3}$ et seront appelés des circuits multiplicateurs. Les signaux de sortie $F_{R1}$, $F_{R2}$ et $F_{R3}$ des circuits multiplicateurs 22, 24 et 26 respectivement sont des impulsions modulées en largeur à une fréquence $2f_i$ et l'information est contenue dans le facteur de forme.

Comme indiqué ci-dessus, la ligne à retard 14 est du type numérique et comprend N registres à décalage en cascade qui fonctionnent à la fréquence $F_{CK}$ d'un signal d'horloge CK de telle sorte que :

$$\tau = N/F_{CK} = (2m + 1)/4f_i$$

avec m = 1, 2, 3, ... .

A chaque signal d'horloge CK, le signal est retardé d'une valeur $\tau/N = \Delta\tau = 1/F_{CK}$.

Le choix du nombre N de registres à décalage est déterminé par le rapport signal/bruit qui est souhaité.

Le choix du paramètre m est déterminé par la déviation en fréquence qui est requise, la sensibilité du dispositif démodulateur qui est souhaitée et la valeur de la fréquence intermédiaire $f_i$.

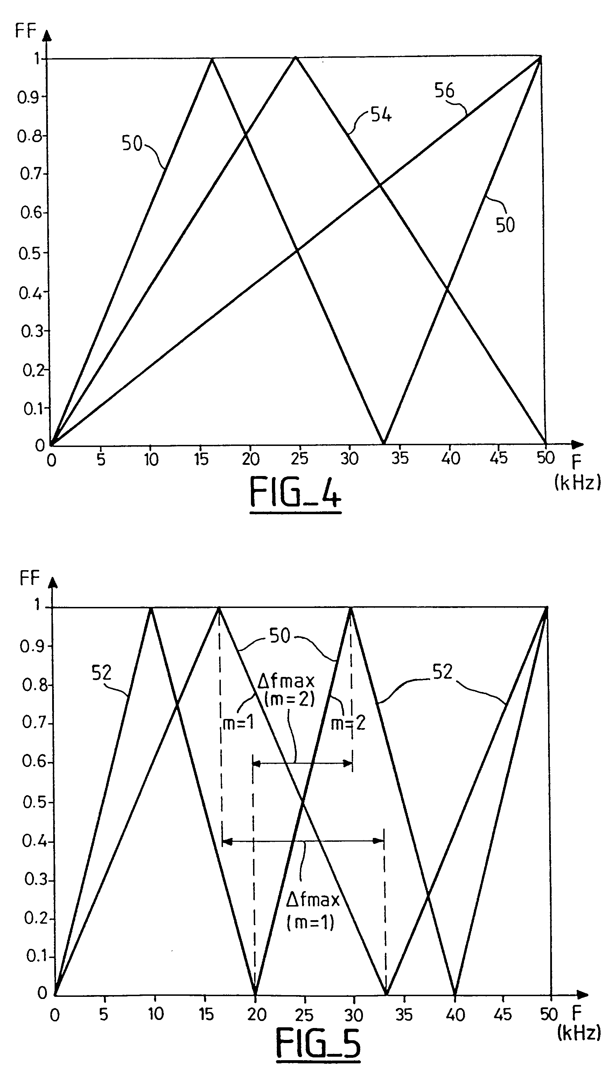

Les courbes 50 et 52 de la figure 5 indiquent la variation du facteur de forme FF du signal $F_{R1}$ en fonction de la fréquence pour une fréquence intermédiaire $f_i$ de 25 kHz et pour des valeurs respectives de m égales à 1 et 2. Ces courbes 50 et 52 montrent que la déviation maximale $\Delta fmax$ en fréquence est donnée par la formule :

$$\Delta fmax = f_i/(2m + 1) \qquad\qquad (1)$$

ce qui donne une déviation maximale de 8,33 kHz pour m = 1 et de 5 kHz pour m = 2.

Le rapport signal/bruit SNR de la ligne à retard 14 est limité par la valeur de l'incrément temporel $\delta\tau$ et dépend donc de N.

La valeur maximale $SNR_{max}$ du rapport signal/bruit est donnée par :

$$SNR_{max} = \frac{6}{(2m + 1)^2} \cdot N^2.$$

A titre d'exemple, si $f_i$ = 25 kHz, m = 1 et N = 300, on obtient $\tau$ = 30 microsecondes, $\Delta\tau$ = 100 nanosecondes et $F_{CK}$ = 10 mégahertz. La déviation maximale en fréquence est alors de 8,33 kHz et la valeur maximale du rapport signal/bruit est égale à 48 décibels.

Avec une telle valeur de N, chaque section 16, 18 ou 20 de la ligne à retard 14 comprend 100 registres à décalage en cascade.

Le signal de suppression du signal démodulé lorsque le rapport signal/bruit est faible est dérivé de la section 18 avec un retard de $1/2f_i$ (signal $F_{MR2}$) et le signal $F_{R2}$ à la sortie du circuit OU EXCLUSIF 24 a un facteur de forme FF qui varie en fonction de la fréquence selon la courbe 54 de la figure 4. Cette courbe 54 est symétrique par rapport à l'axe de fréquence intermédiaire $f_i$ = 25 kHz, c'est-à-dire qu'il est égal à l'unité en l'absence de signal modulé et inférieur à l'unité en présence d'un signal modulé. Le signal $F_{R2}$ (figure 3-E) est donc une indication de la déviation d'un signal modulé en fréquence ou d'un signal de bruit à fréquence intermédiaire. Comme la déviation du signal de bruit à la fréquence intermédiaire est plus large que celle du signal modulé, qui est de l'ordre de 5 kHz en moyenne, on peut discerner le signal modulé du bruit. Le filtre passe-bas 32 lisse le signal $F_{R2}$. Ceci évite que le circuit de suppression du signal démodulé soit activé par les extrêmes de déviation présents dans le signal modulé.

Le signal de contrôle automatique de fréquence est dérivé de la section 16 de la ligne à retard via le circuit OU EXCLUSIF 26 dont le signal de sortie $F_{R3}$ est un signal rectangulaire (Figure 3-G) ; le signal $F_{R3}$ a une fréquence qui est égale à $2f_i$ et son facteur de forme FF (courbe 56 de la figure 4) est une fonction de l'erreur introduite dans la ligne à retard. Ce facteur de forme FF est exactement égal à 0,5 lorsque le retard introduit est égal à $1/4f_i$ (courbe 56). En d'autres mots, lorsque le facteur de forme FF n'est plus égal à 0,5, cela signifie que le retard introduit n'est plus égal à $1/4f_i$ et qu'il faut donc changer la fréquence du signal d'horloge qui commande les décalages des registres.

Pour obtenir ce changement de fréquence, le signal de sortie $F_{R3}$ du circuit OU EXCLUSIF 26 est appliqué au circuit intégrateur 34 dont le signal de sortie commande la fréquence de l'oscillateur 36.

Avec l'utilisation d'une telle boucle de contrôle automatique de fréquence, il n'est plus nécessaire d'ajuster en fréquence l'oscillateur local de la partie radio-fréquence du récepteur.

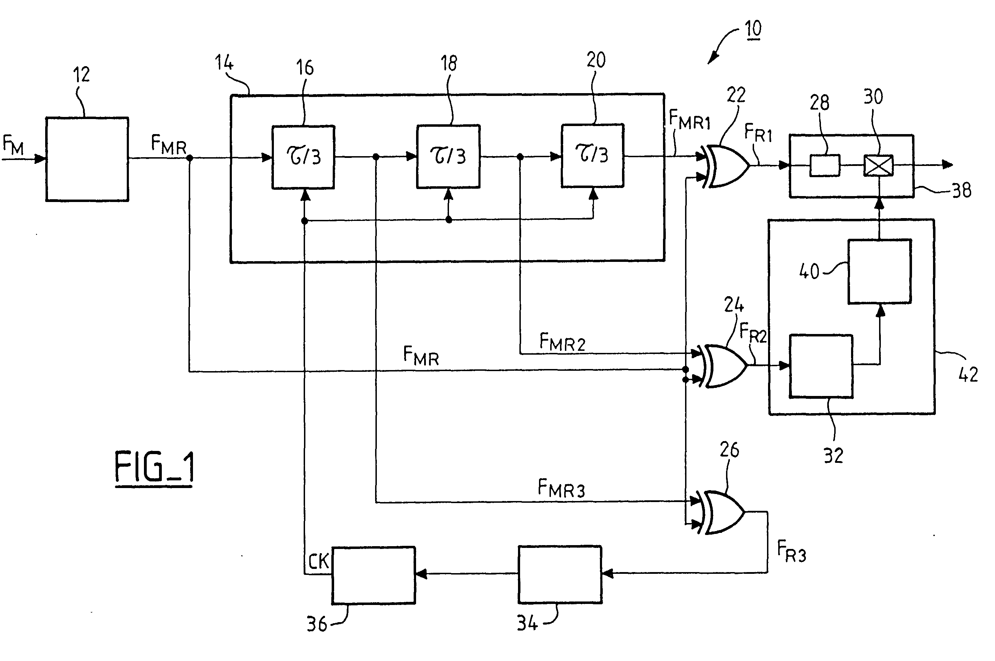

L'invention a été décrite (Figure 1) en mettant en oeuvre une ligne à retard 14 qui comprend trois sections 16, 18 et 20 en cascade, ce qui correspond à un mode préféré de réalisation. Cependant, l'invention peut être mise en oeuvre en utilisant trois lignes à retard en parallèle auxquelles est appliqué le même signal $F_{MR}$, l'une introduisant un premier retard $1/4f_i$ pour fournir le signal $F_{MR3}$, l'autre introduisant un deuxième retard double du premier soit $1/2f_i$ pour fournir le signal $F_{MR2}$ et la troisième introduisant un troisième retard triple du premier soit $3/4f_i$ pour fournir le signal $F_{MR1}$.

Bien entendu, dans la variante comprenant trois lignes à retard en parallèle, les instants de décalage sont commandés par un même signal d'horloge CK fourni par le circuit 36.

Dans certaines applications, le rôle du dispositif de démodulation peut être réduit à réaliser la démodulation, auquel cas il ne comprendra pas le circuit de suppression du signal modulé, ni le circuit de contrôle de fréquence, et ne sera donc constitué que de la ligne à retard 14 de retard $(2m + 1)/4f_i$ suivie des éléments 22 et 28.

Dans d'autres applications, à ce montage de base sera ajouté soit le circuit de suppression du signal modulé, soit le circuit de contrôle de fréquence ou les deux comme décrit en relation avec la figure 1.

## Revendications

1.  Dispositif de démodulation d'un signal modulé en fréquence ($F_M$) autour d'une fréquence intermédiaire ($f_i$) comprenant :

    -   un circuit de transformation (12) du signal modulé en fréquence ($F_M$) en un signal rectangulaire ($F_{MR}$),
    -   une première ligne à retard (14) de type numérique à la borne d'entrée de laquelle est appliqué le signal rectangulaire ($F_{MR}$) de sortie du circuit de transformation (12), ladite ligne à retard (14) fournissant sur une borne de sortie un signal rectangulaire $F_{MR1}$ qui est retardé d'un temps $\tau$ égal à $(2m + 1)/(4f_i)$, m étant un nombre entier, et
    -   un premier circuit multiplicateur (22) aux deux bornes d'entrée duquel sont appliqués le signal rectangulaire ($F_{MR}$) et le signal retardé ($F_{MR1}$) et qui fournit un signal de sortie ($F_{R1}$), et
    -   un premier filtre passe-bas (28) à la borne d'entrée duquel est appliqué le signal de sortie ($F_{R1}$) du premier circuit multiplicateur et qui fournit sur sa borne de sortie un signal démodulé, **caractérisé en ce qu'**il comprend, en outre :

    -   une deuxième ligne à retard de type numérique (16, 18) à la borne d'entrée de laquelle est appliqué le signal rectangulaire ($F_{MR}$) de sortie du circuit de transformation (12), ladite ligne à retard fournissant sur une borne de sortie un signal rectangulaire ($F_{MR2}$) qui est retardé d'un temps égal à $2\tau/3$,
    -   un deuxième circuit multiplicateur (24) aux deux bornes d'entrée duquel sont appliqués le signal rectangulaire ($F_{MR}$) de sortie du circuit de transformation (12) et le signal retardé ($F_{MR2}$) de sortie de ladite deuxième ligne à retard (16, 18) et qui fournit un signal rectangulaire ($F_{R2}$),
    -   un deuxième filtre passe-bas (32) pour filtrer le signal ($F_{R2}$) fourni par ledit deuxième circuit multiplicateur (24),
    -   un comparateur (40) à la borne d'entrée duquel est appliqué le signal filtré fourni par le deuxième filtre passe-bas (32) et qui fournit un signal lorsque le signal filtré est inférieur à un seuil prédéterminé, et

- une porte électronique (30) qui reçoit le signal démodulé et filtré fourni par le premier filtre passe-bas (28) et qui est commandé par le signal de sortie dudit comparateur (40).

**2.** Dispositif de démodulation selon la revendication 1, **caractérisé en ce qu'**il comprend, en outre,

- une troisième ligne à retard (16) de type numérique à la borne d'entrée de laquelle est appliqué le signal rectangulaire ($F_{MR}$) de sortie du circuit de transformation (12), ladite ligne à retard fournissant sur une borne de sortie un signal rectangulaire ($F_{MR3}$) qui est retardé d'un temps égal à $\tau/3$,
- un troisième circuit multiplicateur (26) aux deux bornes d'entrée duquel sont appliqués le signal rectangulaire ($F_{MR}$) de sortie du circuit de transformation (12) et le signal retardé ($F_{MR3}$) de sortie de la troisième ligne à retard (16) et qui fournit un signal ($F_{R3}$),
- un circuit intégrateur (34) auquel est appliqué le signal de sortie ($F_{R3}$) du troisième circuit multiplicateur (26),
- un oscillateur (36) contrôlé en tension auquel est appliqué le signal de sortie du circuit intégrateur (34) et qui fournit des impulsions (CK), lesdites impulsions étant appliquées auxdites première, deuxième et troisième lignes à retard de type numérique de manière à décaler le signal ($F_{MR}$) à chaque impulsion.

**3.** Dispositif de démodulation selon l'une des revendications 1 ou 2, **caractérisé en ce que** les première, deuxième et troisième lignes à retard de type numérique sont réalisées par une seule ligne à retard (14) qui comprend trois sections (16, 18, 20) en cascade, chaque section introduisant un retard $\tau/3$.

**4.** Dispositif de démodulation selon l'une quelconque des revendications précédentes 1 à 3, **caractérisé en ce que** les lignes à retard de type numérique comprennent N registres à décalage en cascade qui fonctionnent à la fréquence $F_{CK}$ d'un signal d'horloge (CK) de telle sorte que :

$$\tau = N/F_{CK}.$$

**5.** Dispositif de démodulation selon l'une quelconque des revendications précédentes 1 à 4, **caractérisé en ce que** le premier, deuxième ou troisième circuit multiplicateur est un circuit logique réalisant la fonction OU EXCLUSIF.

**Patentansprüche**

**1.** Vorrichtung zur Demodulation eines Frequenz ($F_M$)-modulierten Signals um eine Mittelfrequenz ($f_i$) umfassend:

- eine Schaltung (12) zur Transformation eines Frequenz ($F_M$)-modulierten Signals in ein Rechtecksignal ($F_{MR}$),
- eine erste digitale Verzögerungsreihe (14), an deren Eingangsanschluß das Rechtecksignal ($F_{MR}$) von dem Ausgang der Transformationsschaltung (12) angelegt wird, wobei die Verzögerungsreihe (14) über einen Ausgangsanschluß ein Rechtecksignal $F_{MR1}$ weiterleitet, das um eine Zeit $\tau$ gleich $(2m + 1) / (4f_i)$ verzögert ist, wobei m eine ganze Zahl ist, und
- eine erste Multipliziererschaltung (22) mit zwei Eingangsanschlüssen, an welche das Rechtecksignal ($F_{MR}$) und das Verzögerungssignal ($F_{MR1}$) angelegt werden und die ein Ausgangssignal ($F_{R1}$) liefert, und
- ein erstes Tiefpaßfilter (28), an dessen Eingangsanschluß das Ausgangssignal ($F_{R1}$) der ersten Multipliziererschaltung angelegt wird und das an seinem Ausgangsanschluß ein demoduliertes Signal liefert, **dadurch gekennzeichnet, daß** sie außerdem umfasst:

  - eine zweite digitale Verzögerungsreihe (16, 18), an deren Eingangsanschluß das Rechtecksignal ($F_{MR}$) vom Ausgang der Transformationsschaltung (12) angelegt wird, wobei die Verzögerungsreihe an einem Ausgangsanschluß ein Rechtecksignal ($F_{MR2}$) liefert, das um eine Zeit gleich $2\tau / 3$ verzögert ist,
  - eine zweite Multipliziererschaltung (24) mit zwei Eingangsanschlüssen, an welche das Rechtecksignal ($F_{MR}$) vom Ausgang der Transformationsschaltung (12) und das Verzögerungssignal ($F_{MR2}$) vom Ausgang der zweiten Verzögerungsreihe (16, 18) angelegt werden und die ein Rechtecksignal ($F_{R2}$) weiterleitet,
  - ein zweites Tiefpaßfilter (32) zum Filtern des Signals ($F_{R2}$), das von der zweiten Multipliziererschaltung (24) geliefert wird,
  - einen Komparator (40) mit dem Eingangsanschluß, an welchen das von dem zweiten Tiefpaßfilter (32) gelieferte, gefilterte Signal angelegt wird und der ein Signal liefert, wenn das gefilterte Signal unterhalb eines vorbestimmten Schwellwertes liegt, und
  - ein elektronisches Tor (30), das das von dem ersten Tiefpaßfilter (28) gelieferte, gefilterte und demodulierte Signal empfängt und das durch das Ausgangssignal des Komparators (40) gesteuert wird.

**2.** Vorrichtung zur Demodulation nach Anspruch 1, **dadurch gekennzeichnet, daß** sie außerdem umfasst,

- eine dritte digitale Verzögerungsreihe (16), an deren Eingangsanschluß das Rechtecksignal ($F_{MR}$) vom Ausgang der Transformationsschaltung (12) angelegt wird, wobei die Verzögerungsreihe an einem Ausgangsanschluß ein Rechtecksignal ($F_{MR3}$) liefert, das um eine Zeit gleich $\tau / 3$ verzögert ist,

- eine dritte Multipliziererschaltung (26) mit zwei Eingangsanschlüssen, an welche das Rechtecksignal ($F_{MR}$) vom Ausgang der Transformationsschaltung (12) und das Verzögerungssignal ($F_{MR3}$) vom Ausgang der dritten Verzögerungsreihe (16) angelegt werden und die ein Signal ($F_{R3}$) liefert,

- eine Integratorschaltung (34), an welche das Ausgangssignal ($F_{R3}$) der dritten Multipliziererschaltung (26) angelegt wird,

- einen spannungsgesteuerten Oszillator (36), an welchen das Ausgangssignal der Integratorschaltung (34) angelegt wird und der Impulse (CK) liefert, wobei die Impulse an die erste, zweite und dritte digitale Verzögerungsreihe derart angelegt werden, daß sich das Signal ($F_{MR}$) bei jedem Impuls verschiebt.

**3.** Vorrichtung zur Demodulation nach einem der Ansprüche 1 oder 2,
**dadurch gekennzeichnet, daß** die erste, zweite und dritte digitale Verzögerungsreihe durch eine einzige Verzögerungsreihe (14) realisiert sind, die drei Abschnitte (16, 18, 20) in Serienschaltung umfasst, wobei jeder Abschnitt eine Verzögerung von $\tau / 3$ einbringt.

**4.** Vorrichtung zur Demodulation nach einem der Ansprüche 1 bis 3,
**dadurch gekennzeichnet, daß** die digitalen Verzögerungsreihen N Schieberegister in Serienschaltung umfassen, die bei der Frequenz $F_{CK}$ eines Taktsignals (CK) derart funktioniert, daß: $\tau = N/F_{CK}$.

**5.** Vorrichtung zur Demodulation nach einem der Ansprüche 1 bis 4,
**dadurch gekennzeichnet, daß** die erste, zweite und dritte Multipliziererschaltung eine logische Schaltung ist, die die Funktion EXKLUSIV ODER realisiert.

**Claims**

**1.** Demodulator for a signal frequency-modulated ($F_M$) about an intermediate frequency ($f_i$), comprising:

- a circuit (12) for transforming the frequency-modulated ($F_M$) signal into a rectangular signal ($F_{MR}$),

- a first numeric-type delay line (14) having applied to its input the rectangular output signal ($F_{MR}$) from the transformation circuit (12), said delay line (14) providing at an output a rectangular signal $F_{MR1}$ having a time delay $\tau$ equal to $(2m + 1)/(4f_i)$, wherein m is an integer, and

- a first circuit multiplier (22) having applied to its two inputs the rectangular signal ($F_{MR}$) and the delay signal ($F_{MR1}$) and providing an output signal ($F_{R1}$), and

- a first lowpass filter (28) having applied to its input the output signal ($F_{R1}$) of the first circuit multiplier and providing at its output a demodulated signal,

**characterized in that** it further comprises:

- a second numeric-type delay line (16, 18) having applied to its input the rectangular output signal ($F_{MR}$) of the transformation circuit (12), said delay line providing at an output a rectangular signal ($F_{MR2}$) having a time delay equal to $2\tau/3$,

- a second circuit multiplier (24) having applied to its two inputs the rectangular output signal ($F_{MR}$) of the transformation circuit (12) and the delayed output signal ($F_{MR2}$) of said second delay line (16, 18) and providing a rectangular signal ($F_{R2}$),

- a second lowpass filter (32) for filtering the signal ($F_{R2}$) provided by said second circuit multiplier (24),

- a comparator (40) having applied to its input the filtered signal provided by the second lowpass filter (32) and providing a signal wherein the filtered signal is below a predetermined threshold, and

- an electronic port (30) receiving the demodulated and filtered signal provided by the first lowpass filter (28) and being controlled by the output signal of said comparator (40).

**2.** Modulator as claimed in Claim 1, **characterized in that** it further comprises:

- a third numeric-type delay line (16) having applied to its input the rectangular output signal ($F_{MR}$) of the transformation circuit (12), said delay line providing at an output a rectangular signal ($F_{MR3}$) having a delay time equal to $\tau/3$,

- a third circuit multiplier (26) having applied to its two inputs the rectangular output signal ($F_{MR}$) of the transformation circuit (12) and the delayed output signal ($F_{MR3}$) of the third delay line (16) and providing a signal ($F_{R3}$),
- a circuit integrator (34) having applied thereto the output signal ($F_{R3}$) of the third circuit multiplier (26),
- a voltage-controlled oscillator (36) having applied thereto the output signal of the circuit integrator (34) and providing pulses (CK) which are applied to said first, second and third numeric-type delay lines in order to shift the signal ($F_{MR}$) at each pulse.

3. Demodulator as claimed in Claim 1 or 2, **characterized in that** the first, second and third numeric-type delay lines are implemented by means of a single delay line (14) comprising three cascaded sections (16, 18, 20), each section introducing a delay of $\tau/3$.

4. Demodulator as claimed in any one of the preceding Claims 1 to 3, **characterized in that** the numeric-type delay lines comprise N shift registers operating at the frequency $F_{CK}$ of a clock signal (CK) such that $\tau = N/F_{CK}$.

5. Demodulator as claimed in any one of the preceding Claims 1 to 4, **characterized in that** the first, second or third circuit multiplier is a circuit logic realizing the XOR function.

FIG_1

EP 0 760 553 B1

FIG_2A

$F_M$

t

FIG_2B

$F_{MR}$

t

FIG_3A $F_{MR}$

FIG_3B $F_{MR3}$

FIG_3C $F_{R3}$

FIG_3D $F_{MR2}$

FIG_3E $F_{R2}$

FIG_3F $F_{MR1}$

FIG_3G $F_{R1}$

FIG_4

FIG_5